# EUROPEAN PATENT APPLICATION

(11) **EP 4 701 368 A1**
(43) Date of publication of application: **25.02.2026**
(21) Application number: 25172372.2
(22) Date of filing: 24.04.2025
(51) Int. Cl.: H10F 10/166, H10F 71/00, H10F 77/30

(54) **SOLAR CELL, PREPARATION METHOD THEREOF AND PHOTOVOLTAIC MODULE**

(30) Priority: 20.08.2024 CN 202411148014
(71) Applicant: Jinko Solar (Shangrao) Co., Ltd, Shangrao, Jiangxi (CN); Jinko Solar (Haining) Co., Ltd., Haining City, Zhejiang 314415 (CN)
(72) Inventor: CUI, Wei, SHANGRAO ECONOMIC AND TECHNICAL DEVELOPMENT ZONE (CN); JIN, Jingsheng, SHANGRAO ECONOMIC AND TECHNICAL DEVELOPMENT ZONE (CN); LI, Xiangning, SHANGRAO ECONOMIC AND TECHNICAL DEVELOPMENT ZONE (CN); LI, Wen, SHANGRAO ECONOMIC AND TECHNICAL DEVELOPMENT ZONE (CN); WANG, Hao, SHANGRAO ECONOMIC AND TECHNICAL DEVELOPMENT ZONE (CN)
(74) Representative: Müller Schupfner & Partner Patent- und Rechtsanwaltspartnerschaft mbB (Muc)

(57) **Abstract**

Present disclosure relates to the field of photovoltaics and in particular, to a solar cell, a preparation method thereof and a photovoltaic module. The solar cell includes: segmented solar cells (110) formed by segmenting a same whole solar cell (100) in a first direction (X), the whole solar cell (100) has a front surface (100a) and a back surface (100b) which are oppositely arranged in a second direction (Y), the segmented solar cell has a front sub-surface (110a) and a back sub-surface (110b) which are oppositely arranged in the second direction (Y), the front sub-surfaces (110a) of the at least two segmented solar cells (110) formed based on the same whole solar cell (100) are partial regions of the front surface (100a), and the back sub-surfaces (110b) of the at least two segmented solar cells (110) formed based on the same whole solar cell (100) are partial regions of the back surface (100b); the segmented solar cell has a segmentation surface (110c) formed by segmentation, two angles which are supplementary angles to each other are formed between the segmentation surface (110c) and a plane where the back sub-surface is located, and one of the angles is an acute angle; and a passivation layer (101, 111, 121, 131) at least located on the segmentation surface (110c). The embodiments of the present disclosure are at least beneficial to improving the photoelectric conversion efficiency of the solar cell including the segmented solar cell.

## Description

### TECHNICAL FIELD

The present disclosure relates to the field of photovoltaics and in particular, to a solar cell, a preparation method thereof and a photovoltaic module.

### BACKGROUND

In order to reduce the problems of power reduction, hot spots, or the like, of a photovoltaic module caused by the difference of the electrical performances of solar cells, a whole solar cell has a high current, which easily causes an obvious resistance loss. In order to solve the problem of the high power loss of the whole solar cell, the photovoltaic modules in a half-cut form, a laminated form, or the like, are continuously favored by manufacturers and users of terminal modules.

However, whether the half-cut module or the laminated module, the whole solar cell is required to be cut into two same-size or a plurality of segmented solar cells using a laser cutting technology. Mechanical damage and dangling bonds of the segmentation surface of the segmented solar cells in the segmenting process reduce the efficiency of the segmented solar cells, thereby reducing the power of the module.

### SUMMARY

The present disclosure provides a solar cell, a preparation method thereof and a photovoltaic module, which are at least beneficial to improving the photoelectric conversion efficiency of the solar cell including a segmented solar cell.

According to some embodiments of the present disclosure, in an aspect, there is provided a solar cell formed by a segmented solar cell, wherein at least two segmented solar cells are provided and formed by segmenting a same whole solar cell in a first direction, wherein the whole solar cell has a front surface and a back surface which are oppositely arranged in a second direction, the segmented solar cell has a front sub-surface and a back sub-surface which are oppositely arranged in the second direction, the front sub-surfaces of the at least two segmented solar cells formed based on the same solar cell are partial regions of the front surface, and the back sub-surfaces of the at least two segmented solar cells formed based on the same solar cell are partial regions of the back surface; the second direction is a thickness direction of the segmented solar cell, the first direction is intersected with the second direction, the segmented solar cell has a segmentation surface formed by segmentation, two angles which are supplementary angles to each other are formed between the segmentation surface and a plane where the back sub-surface is located, and one of the angles is an acute angle; and a passivation layer at least located on the segmentation surface.

In some embodiments, the segmented solar cell includes at least one segmentation surface, and the passivation layer is located on each segmentation surface.

In some embodiments, in one segmented solar cell, the front sub-surface has an area larger than that of the back sub-surface, a first angle is formed between the at least one segmentation surface and the back sub-surface, and a supplementary angle of the first angle is the acute angle; and/or in the other segmented solar cell, the front sub-surface has an area smaller than that of the back sub-surface, a second angle is formed between the at least one segmentation surface and the back sub-surface, and the second angle is the acute angle.

In some embodiments, the acute angle ranges from 45° to 80°.

In some embodiments, in a third direction, the passivation layer includes at least a first passivation layer and a second passivation layer which are stacked, the first passivation layer includes a silicon oxide material, the second passivation layer includes a metal oxide material, metal elements in the metal oxide material include at least one of Al, Ti, Zn, Zr, Hf, Mo, W, or Ni, and the third direction is perpendicular to the segmentation surface.

In some embodiments, the passivation layer further includes an intermediate passivation layer, the intermediate passivation layer is located between the first passivation layer and the second passivation layer, both the intermediate passivation layer and the first passivation layer contain silicon, and the intermediate passivation layer and the second passivation layer contain same metal elements.

In some embodiments, a material of the intermediate passivation layer includes an oxide with the silicon and the metal elements.

In some embodiments, orthographic projection of the back sub-surface of the segmented solar cell is rectangular, and corners of some rectangles are rounded corners.

According to some embodiments of the present disclosure, in another aspect, there is provided a preparation method of a solar cell, including: providing a whole solar cell; segmenting the whole solar cell with an entire thickness in a first direction to form at least two segmented solar cells, wherein the thickness of the whole solar cell is the same as that of the segmented solar cells in a second direction; the second direction is a thickness direction of the segmented solar cell, the first direction is intersected with the second direction, the segmented solar cell has a front sub-surface and a back sub-surface which are oppositely arranged in the second direction, the segmented solar cell also has a segmentation surface formed by the segmentation, two angles which are supplementary angles to each other are formed between the segmentation surface and a plane where the back sub-surface is located, and one of the angles is an acute angle; and forming a passivation layer at least on the segmentation surface.

According to some embodiments of the present disclosure, in another aspect, there is provided a photovoltaic module, including: a solar cell string formed by connecting the solar cells according to any one of the above descriptions or by connecting a plurality of solar cells formed by the above-mentioned preparation method; a packaging adhesive film for covering a surface of the solar cell string; and a cover plate for covering a surface of the packaging adhesive film away from the solar cell string.

The technical solution of the embodiments of the present disclosure at least has the following advantages.

The segmented solar cell is designed to be formed by segmenting the whole solar cell in the first direction, and the first direction is intersected with the thickness direction of the segmented solar cell, so that the angle between the segmentation surface formed by segmentation and the back sub-surface of the segmented solar cell is not a right angle. In other words, the whole solar cell is obliquely cut to form the segmented solar cells, and the segmentation surface of the segmented solar cell can be regarded as an inclined surface for the front sub-surface and the back sub-surface of the segmented solar cell.

Based on the above design, compared with the manner of segmenting the whole solar cell in the second direction to form the segmentation surface of the segmented solar cell, in some embodiments of the present disclosure, the atom arrangement density on the inclined segmentation surface designed on the segmented solar cell is smaller, the covalent bond surface density is smaller, and a connection between adjacent atoms on the segmentation surface is not firm, which is more favorable for promoting the passivation layer on the segmentation surface to form bonds with dangling bonds on the segmentation surface; that is, the passivation layer more easily saturates the dangling bonds on the segmentation surface. The passivation layer can also passivate other surface defects on the segmentation surface, which is favorable for further improving the capability of the passivation layer to reduce the defect state density of the segmentation surface, and further favorable for reducing the defect state density of the segmentation surface, so as to further reduce recombination centers of the segmentation surface to reduce the recombination probability of carriers. In other words, the segmentation surface of the segmented solar cell is designed to be inclined relative to the back sub-surface thereof rather than perpendicular to the back sub-surface, which is favorable for further improving the passivation effect of the passivation layer on the segmentation surface in cooperation with the passivation function of the passivation layer, so as to further reduce the probability of recombination of the carriers on the segmentation surface and prolong the service life of the carriers, thereby further improving the photoelectric conversion efficiency of the segmented solar cell.

### BRIEF DESCRIPTION OF DRAWINGS

One or more embodiments are illustrated by corresponding figures in the drawings, these illustrations do not constitute limitations on the embodiments, and unless stated otherwise, the figures in the drawings do not constitute a scale limitation. To better describe the technical solutions in the embodiments of the present disclosure or the related art, the following briefly describes the accompanying drawings required for the embodiments. Apparently, the accompanying drawings in the following description show merely some embodiments of the present disclosure, and a person of ordinary skill in the art may still derive other drawings from these accompanying drawings without creative efforts.
FIG. 1 is a schematic segmentation surfaceal structure diagram when a single whole solar cell is segmented into at least 2 segmented solar cells according to one or more embodiments of the present disclosure...
FIG. 2 is a first schematic partial segmentation surfaceal structure diagram of a solar cell according to one or more embodiments of the present disclosure.
FIG. 3 is a schematic top structure diagram when the single whole solar cell is segmented into 2 segmented solar cells according to one or more embodiments of the present disclosure.
FIG. 4 is a schematic top structure diagram when the single whole solar cell is segmented into 4 segmented solar cells according to one or more embodiments of the present disclosure.
FIG. 5 is a schematic top structure diagram when the single whole solar cell is segmented into 9 segmented solar cells according to one or more embodiments of the present disclosure.
FIG. 6 is a second schematic partial segmentation surfaceal structure diagram of the solar cell according to one or more embodiments of the present disclosure.
FIG. 7 is a third schematic partial segmentation surfaceal structure diagram of the solar cell according to one or more embodiments of the present disclosure.
FIG. 8 is a schematic partial segmentation surfaceal structure diagram of a segmented solar cell and a passivation layer in the solar cell according to one or more embodiments of the present disclosure.
FIG. 9 is a graph of element contents for the segmented solar cell and the passivation layer shown in FIG. 8.
FIG. 10 is a fourth schematic partial segmentation surfaceal structure diagram of the solar cell according to one or more embodiments of the present disclosure.
FIG. 11 is a fifth schematic partial segmentation surfaceal structure diagram of the solar cell according to one or more embodiments of the present disclosure.
FIG. 12 is a sixth schematic partial segmentation surfaceal structure diagram of the solar cell according to one or more embodiments of the present disclosure.
FIG. 13 is a seventh schematic partial segmentation surfaceal structure diagram of the solar cell according to one or more embodiments of the present disclosure.
FIG. 14 is an eighth schematic partial segmentation surfaceal structure diagram of the solar cell according to one or more embodiments of the present disclosure.
FIG. 15 is a schematic partial top structure diagram of the solar cell according to one or more embodiments of the present disclosure.
FIG. 16 is a schematic partial perspective structure diagram of a photovoltaic module according to one or more embodiments of the present disclosure. and
FIG. 17 is a schematic segmentation surfaceal structure diagram taken along segmentation surfaceal direction MM1 in FIG. 16.

### DESCRIPTION OF EMBODIMENTS

As is known from the background, the photoelectric conversion efficiency of a solar cell after segmentation is required to be improved.

Analysis shows that, in order to solve the problem of the high power loss of the whole solar cell, the whole solar cell is cut into two same-size or a plurality of segmented solar cells using a laser cutting technology, and then, the segmented solar cells are connected in series by conductive solder strips. A series current is lower than a monolithic current, and the power loss of a photovoltaic module can be improved by the reduction of the current of the segmented solar cell.

However, in the laser segmentation process, if the whole solar cell is locally melted along a set path by laser and the solar cells are then separated along the set path by a mechanical force to realize segmentation, a cutting edge is remained on the segmented solar cell and forms a laser damage region and a mechanical fracture region, so that silicon atoms at the cutting edge cannot keep an original orderly arrangement state, a large number of defect states exist on a surface to become effective recombination centers of carriers, and the large number of carriers are recombined based on the recombination centers, thereby seriously losing the photoelectric conversion efficiency of the segmented solar cell; if the whole solar cell is segmented in a thickness direction of the whole solar cell, a segmentation surface of the formed segmented solar cell is approximately perpendicular to a front surface or a back surface of the solar cell, the atom arrangement density on the segmentation surface formed based on the segmentation angle is large, and the covalent bond surface density on the segmentation surface is large, so that even if a passivation layer is prepared on the segmentation surface to passivate the defect state on the segmentation surface, the large covalent bond surface density can resist saturating the defect state on the segmentation surface by the passivation layer, thus hindering a further improvement of the passivation effect of the passivation layer on the segmentation surface.

Embodiments of the present disclosure provide a solar cell, a preparation method thereof and a photovoltaic module. In the solar cell, an angle between a segmentation surface formed by segmentation and a back sub-surface of a segmented solar cell is not designed to be a right angle. That is, a whole solar cell is obliquely cut to form the segmented solar cells, and the segmentation surface of the segmented solar cell can be regarded as an inclined surface for a front sub-surface and the back sub-surface of the segmented solar cell. Based on this, compared with the manner of segmenting the whole solar cell in a second direction to form the segmentation surface of the segmented solar cell, in some embodiments of the present disclosure, the atom arrangement density on the inclined segmentation surface designed on the segmented solar cell is smaller, the covalent bond surface density is smaller, and a connection between adjacent atoms on the segmentation surface is not firm, which is more favorable for promoting a passivation layer on the segmentation surface to form bonds with dangling bonds on the segmentation surface; that is, the passivation layer more easily saturates the dangling bonds on the segmentation surface. The passivation layer can also passivate other surface defects on the segmentation surface, which is favorable for further improving the capability of the passivation layer to reduce the defect state density of the segmentation surface, so as to further reduce recombination centers of the segmentation surface to reduce the recombination probability of carriers. In other words, the segmentation surface of the segmented solar cell is designed to be inclined relative to the back sub-surface thereof rather than perpendicular to the back sub-surface, which is favorable for further improving the passivation effect of the passivation layer on the segmentation surface in cooperation with the passivation function of the passivation layer, so as to further reduce the probability of recombination of the carriers on the segmentation surface and prolong the service life of the carriers, thereby further improving the photoelectric conversion efficiency of the segmented solar cell.

In the description of embodiments of the present disclosure, technical terms "first", "second" and the like are intended only to distinguish different objects, which shall not be construed as indicating or implying a relative importance, or implicitly specifying the number, a particular order or primary and secondary relations of the indicated technical features. In the description of embodiments of the present disclosure, "a plurality of" means two or more, unless specifically stated otherwise.

The "embodiments" mentioned herein means that particular features, structures or characteristics described with reference to the embodiments may be included in one or more embodiments of the present disclosure. Phrases appearing at various positions of the specification neither always refer to the same embodiments, nor separate or alternative embodiments that are mutually exclusive with other embodiments. It is explicitly and implicitly understood by those skilled in the art that the embodiments described herein may be combined with other embodiments.

In the description of embodiments of the present disclosure, the term "and/or" is merely an association relationship describing associated objects, indicating that three relationships may exist. For example, A and/or B indicates that there are three cases of A, A and B together, and B. In addition, the character "/" herein generally means that associated objects before and after "/"are in an "or" relationship.

In the description of embodiments of the present disclosure, the term "a plurality of" means two or more. Similarly, "a plurality of groups" means two or more groups, and "a plurality of pieces" means two or more pieces.

In the description of embodiments of the present disclosure, the orientation or position relationship indicated by the technical terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", etc. are based on the orientation or position relationship shown in the accompanying drawings and are only intended to facilitate the description of embodiments of the present disclosure and simplify the description, rather than indicating or implying that the device or element referred to must have a particular orientation or be constructed and operated in a particular orientation, and therefore are not to be interpreted as limitations on the embodiments of the present disclosure.

In the description of embodiments of the present disclosure, unless specifically stated and limited, the technical terms "mounting," "coupling", "connecting" and "fixing" should be understood in a broad sense, such as, a fixed connection, a detachable connection, or an integral connection; a mechanical connection or an electrical connection; a direct connection, an indirect connection through an intermediate medium, an internal connection of two elements, or an interaction of two elements. For those of ordinary skill in the art, the specific meanings of the above terms in embodiments of the present disclosure can be understood on case-by-case.

In the drawings corresponding to embodiments of the present disclosure, the thicknesses and areas of layers are exaggerated for better understanding and ease of description. When a component (e.g., layer, film, region, or base) is described as being on another component or on a surface thereof, it can be "directly" on the surface of the other component or a third component can be present between the two components. Conversely, when a component is described as being on a surface of another component or a surface of a component is described as being formed or provided with another component, there is no third component between the two components. Furthermore, when a component is described as being formed "substantially" on another component, the component is not formed on the entire surface (or front surface) of the other component, nor on a partial edge of the entire surface.

In the description of embodiments of the present disclosure, when a component "includes" another component, other components are not excluded unless otherwise stated, and the other components may be further included. Furthermore, when a layer, film, region, plate, or the like, is referred to as being "on/located on" another component, it can be "directly on" the other component (i.e., on a surface of the other component without other components therebetween) or another component is present therebetween. Furthermore, when a layer, film, region, plate, or the like, is "directly on" another component, or when a layer, film, region, plate, or the like, is on a surface of another component, no other component is located therebetween.

The terminology used in the description of various described embodiments herein is for the purpose of describing particular embodiments only and is not intended to be limiting. As used in the description of the various described embodiments and the appended claims, the "component" is also intended to include the plural form unless the context clearly indicates otherwise. The component includes a layer, a film, a region, a plate, or the like.

Embodiments of the present disclosure will be described in detail below with reference to the accompanying drawings. However, it may be appreciated by those of ordinary skill in the art that in the embodiments of the present disclosure, numerous technical details are set forth in order to enable a reader to better understand of the embodiments of the present disclosure. However, it is possible to implement the technical solution claimed by the embodiments of the present disclosure without these technical details and variations and modifications based on the following embodiments.

One or more embodiments of the present disclosure provide a solar cell, which will be described in detail below with reference to the accompanying drawings.

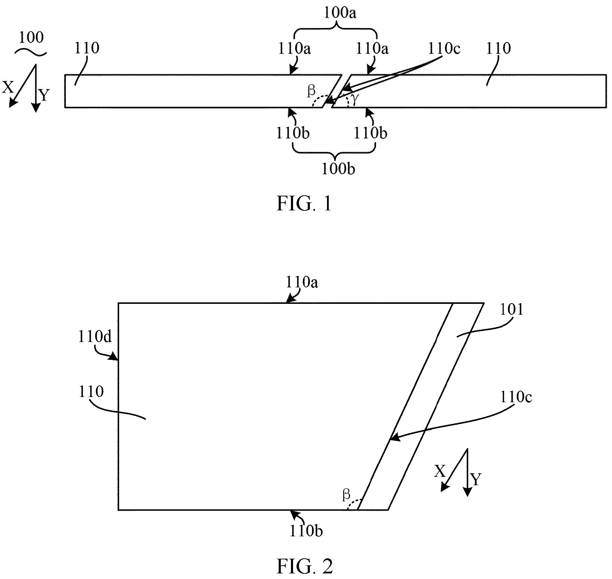

Referring to FIG. 1 and FIG. 2, the solar cell is formed by segmented solar cells, and at least two segmented solar cells 110 are provided and formed by segmenting a same whole solar cell 100 in a first direction X, wherein the whole solar cell 100 has a front surface 100a and a back surface 100b which are oppositely arranged in a second direction Y, the segmented solar cell 110 has a front sub-surface 110a and a back sub-surface 110b which are oppositely arranged in the second direction Y, the front sub-surfaces 110a of the at least two segmented solar cells 110 formed based on the same whole solar cell 100 are partial regions of the front surface 100a, and the back sub-surfaces 110b of the at least two segmented solar cells 110 formed based on the same whole solar cell 100 are partial regions of the back surface 100b; the second direction Y is a thickness direction of the segmented solar cell 110, the first direction X is intersected with the second direction Y, the segmented solar cell 110 has a segmentation surface 110c formed by segmentation, two angles which are supplementary angles to each other are formed between the segmentation surface 110c and a plane where the back sub-surface 110b is located, and one of the angles is an acute angle; and a passivation layer 101 at least located on the segmentation surface 110c.

FIG. 1 is a schematic segmentation surfaceal structure diagram when the single whole solar cell is segmented into at least 2 segmented solar cells according to one or more embodiments of the present disclosure. FIG. 2 is a first schematic partial segmentation surfaceal structure diagram of the solar cell according to one or more embodiments of the present disclosure.

In some cases, based on segmentation, a large number of defect states, mechanical damage caused by the segmentation, or other surface defects may exist on the segmentation surface 110c formed by the segmentation of the segmented solar cell 110, and impurities may be easily introduced on the segmentation surface 110c based on various surface defects existing on the segmentation surface 110c. These defects and impurities tend to act as recombination centers for electron-hole pairs to shorten the lifetime of carriers, thus reducing the photoelectric conversion efficiency of the segmented solar cell 110. It should be noted that the segmentation includes, but is not limited to, laser cutting, which easily leaves laser damage on the segmentation surface 110c.

It is noted that the front sub-surfaces 110a of the at least two segmented solar cells 110 formed based on the same whole solar cell 100 are the partial regions of the front surface 100a, and the back sub-surfaces 110b of the at least two segmented solar cells 110 formed based on the same whole solar cell 100 are the partial regions of the back surface 100b, so that the segmented solar cells 110 are formed by cutting the whole solar cell 100 from the front surface 100a to the back surface 100b thereof, or from the back surface 100b to the front surface 100a thereof, and therefore, both a thickness direction of the whole solar cell 100 and the thickness direction of the segmented solar cells 110 are the second direction Y. Moreover, a cutting direction of the whole solar cell 100 is defined; that is, the segmented solar cells 110 are formed by segmenting the same whole solar cell 100 in the first direction X, and the first direction X is intersected with the thickness direction of the segmented solar cells 110. In this way, the angle between the segmentation surface 110c formed by the segmentation and the back sub-surface 110b of the segmented solar cell 110 is not a right angle. In other words, the whole solar cell 100 is obliquely cut to form the segmented solar cells 110, and the segmentation surface of the segmented solar cell 110 can be regarded as an inclined surface for the front sub-surface 110a and the back sub-surface 110b of the segmented solar cell 110.

Moreover, compared with the manner of segmenting the whole solar cell in the thickness direction thereof to form the segmentation surface of the segmented solar cell, in some embodiments of the present disclosure, the atom arrangement density on the inclined segmentation surface 110c designed on the segmented solar cell 110 is smaller, the covalent bond surface density is smaller, and a connection between adjacent atoms on the segmentation surface 110c is not firm, which is more favorable for promoting the passivation layer 101 on the segmentation surface 110c to form bonds with dangling bonds on the segmentation surface 110c; that is, the passivation layer 101 more easily saturates the dangling bonds on the segmentation surface 110c. The passivation layer 101 can also passivate other surface defects on the segmentation surface 110c, which is favorable for further improving the capability of the passivation layer 101 to reduce the defect state density of the segmentation surface 110c, so as to further reduce recombination centers of the segmentation surface 110c to reduce the recombination probability of carriers. In other words, the segmentation surface 110c of the segmented solar cell 110 is designed to be inclined relative to the back sub-surface 110b thereof rather than perpendicular to the back sub-surface, which is favorable for further improving the passivation effect of the passivation layer 101 on the segmentation surface 110c in cooperation with the passivation function of the passivation layer 101, so as to further reduce the probability of recombination of the carriers on the segmentation surface 110c and prolong the service life of the carriers, thereby further improving the photoelectric conversion efficiency of the segmented solar cell.

In some cases, compared with the case where the segmentation surface 110c of the formed segmented solar cell 110 is not passivated after the whole solar cell 100 is segmented, the inclination of the segmentation surface 110c relative to the back sub-surface 110b in combination with the passivation of the segmentation surface 110c by the passivation layer 101 is beneficial to increasing the open-circuit voltage Voc of the solar cell by about 3.2 mV, the fill factor FF by about 0.80%, and the photoelectric conversion efficiency Eff by about 0.33%.

In some other cases, compared with the case where the segmentation surface 110c of the formed segmented solar cell 110 is passivated after the whole solar cell is segmented in the thickness direction thereof to form the segmentation surface of the segmented solar cell, in the solar cell including the segmented solar cell 110 according to one or more embodiments of the present disclosure, the inclination of the segmentation surface 110c relative to the back sub-surface 110b is beneficial to increasing the open-circuit voltage Voc of the solar cell by about 2.5 mV, the fill factor FF by about 0.66%, and the photoelectric conversion efficiency Eff by about 0.25%.

Embodiments of the present disclosure will be described in more detail below with reference to the accompanying drawings.

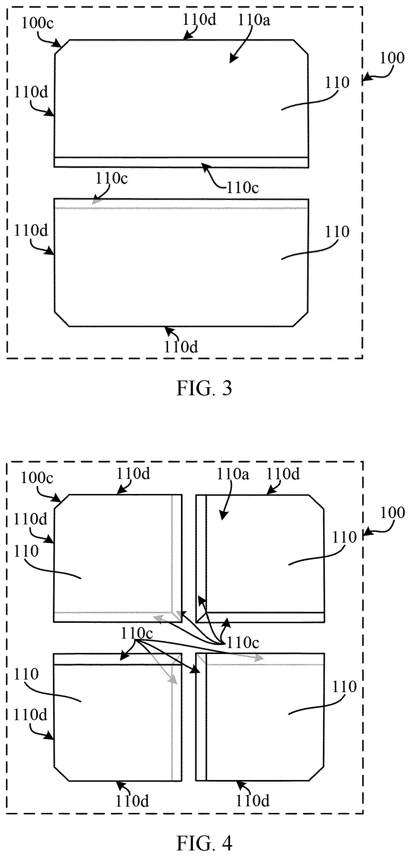

In some embodiments, referring to FIG. 3, FIG. 4 or FIG. 5, the segmented solar cell 110 includes at least one segmentation surface 110c, and the passivation layer 101 is located on each segmentation surface 110c.

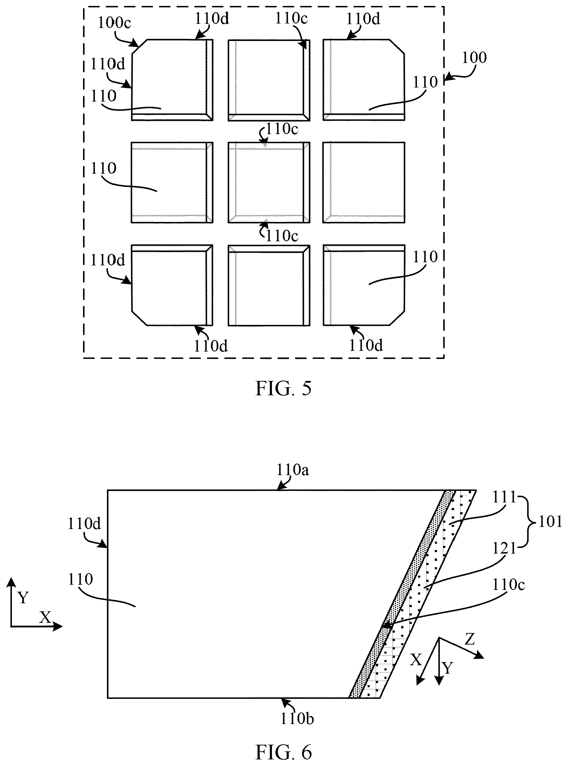

FIG. 3 is a schematic top structure diagram when the single whole solar cell is segmented into 2 segmented solar cells according to one or more embodiments of the present disclosure. FIG. 4 is a schematic top structure diagram when the single whole solar cell is segmented into 4 segmented solar cells according to one or more embodiments of the present disclosure. FIG. 5 is a schematic top structure diagram when the single whole solar cell is segmented into 9 segmented solar cells according to one or more embodiments of the present disclosure. Furthermore, in order to clearly illustrate the segmentation surface 110c in each segmented solar cell 110, a perspective drawing manner is adopted for some segmented solar cells 110 in FIG. 3 to FIG. 5.

The relationship between the segmented solar cell 110 and the whole solar cell 100 will be described in detail below.

In some examples, referring to FIG. 3, N is 2, and each segmented solar cell 110 is a half of the whole solar cell 100. In other words, the segmented solar cell 110 is a half-cut solar cell.

In some cases, with continued reference to FIG. 3, successive corners of the four side surfaces of the whole solar cell 100 are rounded corners 100c, and based on this, successive corners of a side surface 110d of the segmented solar cell 110 not subjected to segmentation are still rounded corners 100c, but corners of the segmentation surface 110c of the segmented solar cell 110 connected with the side surface 110d are not rounded corners.

In some cases, as shown in FIG. 1 and FIG. 3, the angle between the segmentation surface 110c and the back sub-surface 110b of one of the two segmented solar cells 110 belonging to the same whole solar cell 100 is a first angle β, the angle between the segmentation surface 110c and the back sub-surface 110b of the other segmented solar cell 110 is a second angle γ, and the first angle β is supplementary to the second angle γ. It should be noted that, in FIG. 1, the first angle β is an obtuse angle, and the second angle γ is an acute angle.

In some other examples, referring to FIG. 4, N is 4, and each segmented solar cell 110 is a quarter of the whole solar cell 100.

In some cases, with continued reference to FIG. 4, a segmentation path in the whole solar cell 100 is "cross" shaped, and one corner of any segmented solar cell 110 is a rounded corner 100c. Moreover, any of the four segmented solar cells 110 belonging to the same whole solar cell 100 has two segmentation surfaces 110c.

In one or more examples, referring to FIG. 4, the angle between one of the two segmentation surfaces 110c of the same segmented solar cell 110 and the back sub-surface 110b of the segmented solar cell 110 is a third angle (not shown), the angle between the other segmentation surface 110c and the back sub-surface 110b of the segmented solar cell 110 is a fourth angle (not shown), and both the third angle and the fourth angle are acute angles. In one or more examples, with continued reference to FIG. 4, the angle between one of the two segmentation surfaces 110c of the same segmented solar cell 110 and the back sub-surface 110b of the segmented solar cell 110 is a third angle (not shown), the angle between the other segmentation surface 110c and the back sub-surface 110b of the segmented solar cell 110 is a fourth angle (not shown), and both the third angle and the fourth angle are obtuse angles. In one or more examples, with continued reference to FIG. 4, the angle between one of the two segmentation surfaces 110c of the same segmented solar cell 110 and the back sub-surface 110b of the segmented solar cell 110 is a third angle (not shown), the angle between the other segmentation surface 110c and the back sub-surface 110b of the segmented solar cell 110 is a fourth angle (not shown), one of the third angle and the fourth angle is an acute angle, and the other one is an obtuse angle.

It should be noted that there are many possibilities for the first direction X intersected with the second direction Y, and based on the selection of the first direction X, the two segmentation surfaces 110c of the same segmented solar cell 110 may present different inclination states, and may be flexibly designed according to requirements in practical applications.

In other cases, the whole solar cell may be divided into four segmented solar cells in a fixed direction, and then, each of only two segmented solar cells has two rounded corners. Among the four segmented solar cells belonging to the same whole solar cell, each of the two segmented solar cells with the rounded corners has only one segmentation surface, and each of the rest two segmented solar cells has two segmentation surfaces opposite to each other in the fixed direction.

It should be noted that, based on the segmentation manner of the whole solar cell 100, among the at least two segmented solar cells 110 belonging to the same whole solar cell 100, the numbers of the segmentation surfaces 110c of different segmented solar cells 110 and the inclination states of the segmentation surfaces 110c may be different, and may be flexibly designed according to requirements in practical applications.

In some other examples, referring to FIG. 5, N is 9, and each segmented solar cell 110 is a ninth of the whole solar cell 100.

It should be noted that all of the three examples shown in FIG. 3 to FIG. 5 are examples in which the whole solar cell 100 is segmented into at least two segmented solar cells 110, and in practical applications, the number N of the segmented solar cells 110 formed by segmenting the single whole solar cell 100 may be adjusted according to requirements, and for example, N may be 3, 5, 6, 7, 8, 10, or the like. Furthermore, in some embodiments of the present disclosure, the segmentation path of the whole solar cell 100 is not limited, and can be flexibly adjusted according to requirements.

In the above embodiments, referring to FIG. 1 to FIG. 5, in some segmented solar cells 110, the area of the front sub-surface 110a may be larger than that of the back sub-surface 110b, the first angle β is formed between the at least one segmentation surface 110c and the back sub-surface 110b, and a supplementary angle of the first angle β is an acute angle; that is, the first angle β formed between the segmentation surface 110c and the back sub-surface 110b is an obtuse angle, and an acute angle is further formed between the segmentation surface 110c and the plane where the back sub-surface 110b is located.

In the above embodiments, referring to FIG. 1 to FIG. 5, in the other segmented solar cells 110, the area of the front sub-surface 110a may be smaller than that of the back sub-surface 110b, the second angle γ is formed between the at least one segmentation surface 110c and the back sub-surface 110b, the second angle γ is an acute angle, and an obtuse angle is further formed between the segmentation surface 110c and the plane where the back sub-surface 110b is located.

It should be noted that, in practical applications, for the segmented solar cell having at least two segmentation surfaces, the angles between some segmentation surfaces and the back sub-surface of the segmented solar cell are acute angles, and angles between the other segmentation surfaces and the back sub-surface of the segmented solar cell are obtuse angles, so that the area of the front sub-surface of the segmented solar cell may be equal to the area of the back sub-surface of the segmented solar cell.

It is noted that, in the above embodiments, referring to FIG. 1 to FIG. 5, for any segmentation surface 110c, the angle formed between the segmentation surface 110c and the back sub-surface 110b corresponding thereto is one of an acute angle or an obtuse angle.

In the above embodiments, referring to FIG. 3 to FIG. 5, orthographic projection of the back sub-surface 110b of the segmented solar cell 110 may be rectangular, and corners of some rectangles are the rounded corners 100c.

In the above embodiments, referring to FIG. 1 to FIG. 5, the acute angle formed between the segmentation surface 110c and the plane where the back sub-surface 110b is located may range from 45° to 80°. If the acute angle is smaller than 45°, the inclination of the segmentation surface 110c relative to the back sub-surface 110b is excessively large, so that a part of the segmented solar cell 110 including the segmentation surface 110c can be regarded as a tip protruding from the whole segmented solar cell 110. The smaller the acute angle is, the more the tip protrudes, and the more easily the tip is broken under pressure, which is not favorable for improving the structural stability of the segmented solar cell 110. If the acute angle is greater than 80°, the inclination of the segmentation surface 110c relative to the back sub-surface 110b is excessively small, which is not favorable for reducing the atom arrangement density on the segmentation surface 110c, and thus not favorable for improving the passivation effect of the passivation layer 101 on the segmentation surface 110c. Therefore, the acute angle is designed to range from 45° to 80°, and the inclination of the segmentation surface 110c relative to the back sub-surface 110b is controlled, which is favorable for improving the structural stability of the segmented solar cell 110 and reducing the probability of damage of the segmented solar cell 110, and meanwhile effectively reduces the atom arrangement density on the segmentation surface 110c to improve the passivation effect of the passivation layer 101 on the segmentation surface 110c.

In some examples, the acute angle formed between the segmentation surface 110c and the plane where the back sub-surface 110b is located may range from 45° to 50°. For example, the acute angle may be 46°, 47°, 48° or 49°, which is beneficial to making the segmentation surface 110c approach the fcc (111) crystal plane of the segmented solar cell 110. It is noted that, compared with other crystal planes, the fcc (111) crystal plane has the minimum atom arrangement density, the minimum covalent bond surface density and the infirm connection between adjacent atoms, and based on this, the acute angle formed between the segmentation surface 110c and the plane where the back sub-surface 110b is located may be designed to range from 45° to 50°, which is beneficial to reducing the atom arrangement density on the segmentation surface 110c as much as possible, and enhancing the capability of the passivation layer 101 to saturate the dangling bonds on the segmentation surface 110c as much as possible, and thus is beneficial to further improving the passivation effect of the passivation layer 101 on the segmentation surface 110c, so as to further reduce the probability of the recombination of the carriers on the segmentation surface 110c, and improve the lifetime of the carriers, thereby further improving the photoelectric conversion efficiency of the segmented solar cell.

In some other examples, the acute angle formed between the segmentation surface 110c and the plane where the back sub-surface 110b is located may be 55°, 60°, 65°, 70°, 75°, 80°, 85°, or the like.

In some embodiments, referring to FIG. 6 which is a second schematic partial segmentation surfaceal structure diagram of the solar cell according to one or more embodiments of the present disclosure, in a third direction Z, the passivation layer 101 includes at least a first passivation layer 111 and a second passivation layer 121 which are stacked, the first passivation layer 111 includes a silicon oxide material, the second passivation layer 121 includes a metal oxide material, metal elements in the metal oxide material include at least one of Al, Ti, Zn, Zr, Hf, Mo, W, or Ni, and the third direction Z is perpendicular to the segmentation surface 110c.

Thus, on the one hand, the first passivation layer 111 is designed to contain the silicon oxide material, and the segmentation surface 110c is chemically passivated by the silicon oxide material. For example, the dangling bonds on the segmentation surface 110c are saturated by oxygen atoms of the first passivation layer 111, and the capability of the oxygen atoms to saturate the dangling bonds on the segmentation surface 110c is enhanced with the aid of the segmentation surface 110c inclined relative to the back sub-surface 110b, so as to further reduce the defect state density of the segmentation surface 110c to further reduce the recombination centers of the segmentation surface 110c to reduce the carrier recombination probability. On the other hand, the second passivation layer 121 is designed to include the metal oxide material, the metal elements in the metal oxide material include at least one of Al, Ti, Zn, Zr, Hf, Mo, W, or Ni, so that the metal elements in the second passivation layer 121 enable the second passivation layer 121 to have fixed charges with a high density, and the fixed charges with a high density can generate a large electric field, so as to perform good field effect passivation on the segmentation surface 110c. For example, large energy band bending is generated between the second passivation layer 121 and the segmentation surface 110c to block minority carriers from migrating to the segmentation surface 110c and reduce the concentration of the minority carriers at the segmentation surface 110c, which is beneficial to reducing the probability of recombination of majority carriers and the minority carriers at the segmentation surface 110c. In this way, the first passivation layer 111 and the second passivation layer 121 cooperate with each other and with the segmentation surface 110c inclined relative to the back sub-surface 110b, which is beneficial to significantly improving the photoelectric conversion efficiency of the segmented solar cell 110, thereby improving the photoelectric conversion efficiency of the solar cell.

Furthermore, the density of the silicon oxide material is high, which is favorable for improving the density of the first passivation layer 111, so that the stability of the first passivation layer 111 is high, which is favorable for protecting, by the first passivation layer 111, the segmentation surface 110c covered by the first passivation layer 111. For example, the segmentation surface 110c can be prevented from being invaded by external impurities.

Moreover, the silicon oxide material also brings a good potential induced degradation (PID) resisting effect. Since a packaging material of a photovoltaic module formed subsequently based on the solar cell cannot realize complete isolation from the outside, moisture may enter the solar cell in a humid environment through the packaging material or a back sheet for edge sealing. At this point, sodium ions are generated from glass in the packaging material, and the sodium ions move to the surface of the solar cell under the action of an external electric field to generate a PID phenomenon, which reduces the photoelectric conversion efficiency of the solar cell. The silicon oxide material has good compactness and insulativity, and therefore brings a good effect of avoiding that the moisture enters the segmentation surface 110c to enter the segmented solar cell 110, and thus brings the good PID resisting effect. Thus, even if the packaging material of the photovoltaic module cannot realize complete insulation, and the moisture enters the environment where the solar cell is located through the packaging material for edge sealing, the film made of the silicon oxide material can prevent the sodium ions in the glass in the packaging material from moving to the segmentation surface 110c, thereby preventing the PID phenomenon, and keeping a high photoelectric conversion rate of the solar cell.

In some cases, the first passivation layer 111 and the second passivation layer 121 are stacked on the segmentation surface 110c in a direction perpendicular to the first direction X, i.e., the direction Z, and the first passivation layer 111 is closer to the segmentation surface 110c than the second passivation layer 121. For example, the first passivation layer 111 may cover the segmentation surface 110c. In this way, a path of migration of the oxygen atoms in the first passivation layer 111 to the surface defect on the segmentation surface 110c is advantageously shortened, so as to improve the chemical passivation effect of the oxygen atoms in the first passivation layer 111 on the segmentation surface 110c. Moreover, compared with the second passivation layer 121 including the metal oxide material, lattices of the first passivation layer 111 including the silicon oxide material better match lattices of a base in the segmented solar cell 110, which is beneficial to avoiding the problem of a large lattice mismatch between the segmentation surface 110c and the second passivation layer 121 when the segmentation surface 110c is in direct contact with the second passivation layer 121, so as to avoid the problem of increased surface defects caused by the lattice mismatch, thereby improving the interface passivation effect on the segmentation surface 110c.

The metal oxide material contained in the second passivation layer 121 is exemplified below.

In some examples, the metal elements in the metal oxide material include Al. That is, the second passivation layer 121 includes an aluminum oxide material. On the one hand, the aluminum oxide material makes the second passivation layer 121 have high-density fixed negative charges (Q_{f} is about 10¹² cm⁻² to 10¹³ cm⁻²), which is beneficial to improving the field passivation effect of the second passivation layer 121 on the segmentation surface 110c, so as to reduce the probability of recombination of the carriers at the segmentation surface 110c, thereby facilitating an improvement of the photoelectric conversion efficiency of the segmented solar cell 110. On the other hand, in a technology for forming the second passivation layer 121 containing the aluminum oxide material, a proper number of hydrogen ions may also be provided in the second passivation layer 121, so that the second passivation layer 121 brings a good hydrogen passivation effect on the segmentation surface 110c. For example, the proper number of hydrogen ions in the second passivation layer 121 can effectively saturate the dangling bonds on the segmentation surface 110c by migration, as well as inhibit recombination of the hydrogen ions with the carriers, which is beneficial to ensuring that the carriers effectively converge on a corresponding electrode in the segmented solar cell 110, so as to further improve the photoelectric conversion efficiency of the segmented solar cell 110.

In some other examples, the metal elements in the metal oxide material include Mo. That is, the second passivation layer 121 includes a molybdenum oxide material. On the one hand, the molybdenum oxide material makes the second passivation layer 121 have a high work function, and is also beneficial to enabling the second passivation layer 121 to bring a good field passivation effect on the segmentation surface 110c. On the other hand, in a technology for forming the second passivation layer 121 containing the molybdenum oxide material, a proper number of hydrogen ions may also be provided in the second passivation layer 121, so that the second passivation layer 121 brings the good hydrogen passivation effect on the segmentation surface 110c.

It should be noted that the above two examples are illustrative of the good passivation effect of the metal oxide material in the second passivation layer 121 on the segmentation surface 110c. In practical applications, the metal elements in the metal oxide material include at least one of Al, Ti, Zn, Zr, or Hf, which enable the second passivation layer 121 to have the high-density fixed negative charges, so as to bring the good field passivation effect on the segmentation surface 110c. The metal elements in the metal oxide material include at least one of Mo, W, or Ni, which enable the second passivation layer 121 to have high-density fixed positive charges or the high work function, so as to bring the good field passivation effect on the segmentation surface 110c.

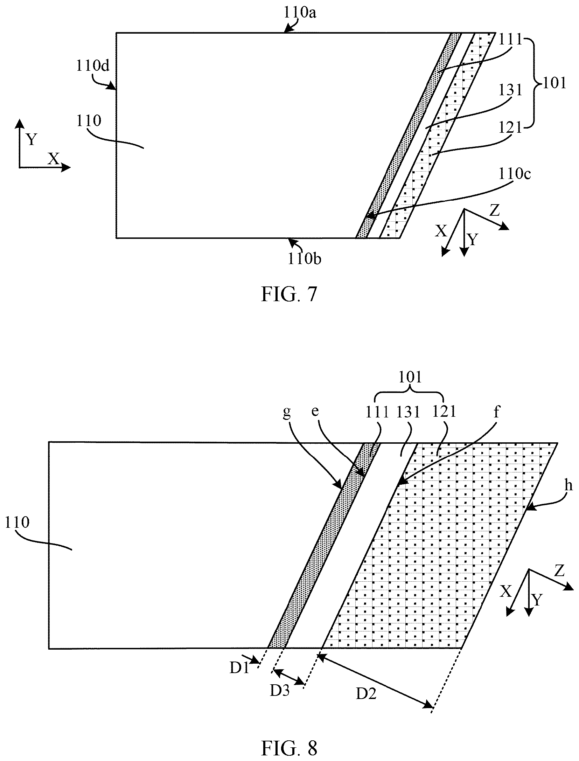

In some embodiments, referring to FIG. 7 which is a third schematic partial segmentation surfaceal structure diagram of the solar cell according to one or more embodiments of the present disclosure, the passivation layer 101 may further include an intermediate passivation layer 131, the intermediate passivation layer 131 is located between the first passivation layer 111 and the second passivation layer 121, both the intermediate passivation layer 131 and the first passivation layer 111 contain silicon, and the intermediate passivation layer 131 and the second passivation layer 121 contain same metal elements.

It is noted that the intermediate passivation layer 131 has both the same element, i.e., silicon, as the first passivation layer 111 and the same element, i.e., metal element, as the second passivation layer 121. In this way, the intermediate passivation layer 131 may facilitate lattices at an interface where the intermediate passivation layer 131 and the first passivation layer 111 are in contact with each other to better match by using the silicon, as well as facilitate lattices at an interface where the intermediate passivation layer 131 and the second passivation layer 121 are in contact with each other to better match by using the metal element, which is beneficial to avoiding the problem of a large lattice mismatch between the first passivation layer 111 and the second passivation layer 121 when the first passivation layer 111 and the second passivation layer 121 are in direct contact with each other, so as to avoid the problem of increased surface defects caused by the lattice mismatch, thereby improving the interface passivation effect of the passivation layer 101 on the segmented solar cell 110, for example, improving the passivation effect on the segmentation surface 110c.

In other words, the intermediate passivation layer 131 plays a transition role to improve the matching degree of the lattices at the interfaces where the first passivation layer 111, the intermediate passivation layer 131 and the second passivation layer 121 are in sequential contact, and prevent voids and dislocations at the interfaces where the first passivation layer 111, the intermediate passivation layer 131 and the second passivation layer 121 are in sequential contact, so as to improve the uniformity of the passivation layer 101, thereby improving the interface passivation effect of the passivation layer 101 on the segmented solar cell 110. Moreover, the connection strength between the first passivation layer 111 and the intermediate passivation layer 131 and the connection strength between the intermediate passivation layer 131 and the second passivation layer 121 may be advantageously improved by means of the intermediate passivation layer 131 to avoid the problem of slipping or falling of the first passivation layer 111 and the intermediate passivation layer 131, or of the intermediate passivation layer 131 and the second passivation layer 121 relative to each other, thereby facilitating an improvement of the structural stability of the passivation layer 101.

In some embodiments, with continued reference to FIG. 7, a material of the intermediate passivation layer 131 includes an oxide with silicon and metal elements. Thus, it can be ensured that the intermediate passivation layer 131 has both the same elements as the first passivation layer 111 and the same elements as the second passivation layer 121, so that the intermediate passivation layer 131 serves as a transition layer between the first passivation layer 111 and the second passivation layer 121, and oxygen atoms in the intermediate passivation layer 131 can be utilized. The dangling bonds on the segmentation surface 110c are further saturated based on the migration of the oxygen atoms towards the segmentation surface 110c, so as to further reduce the defect state density of the segmentation surface 110c, thereby further reducing the recombination centers of the segmentation surface 110c to reduce the carrier recombination probability.

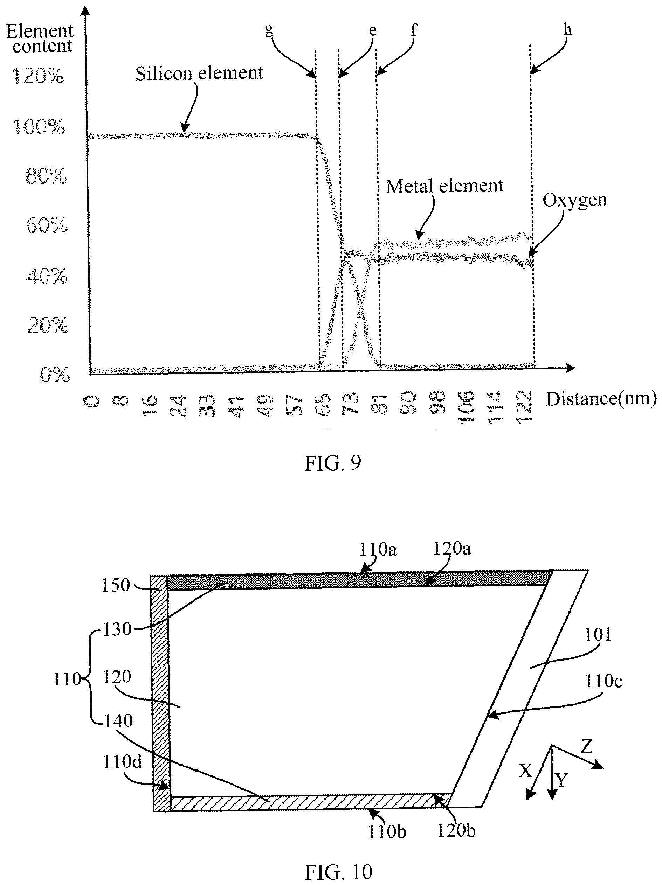

In some embodiments, as shown in FIG. 8 and FIG. 9, the intermediate passivation layer 131 and the first passivation layer 111 are in contact at a first surface e, and the intermediate passivation layer 131 and the second passivation layer 121 are in contact at a second surface f. The content of the silicon at the first surface e is higher than that at the second surface f, and the content of the metal element at the first surface e is lower than that at the second surface f.

FIG. 8 is a schematic partial segmentation surfaceal structure diagram of the segmented solar cell and the passivation layer in the solar cell according to one or more embodiments of the present disclosure. FIG. 9 is a graph of element contents for the segmented solar cell and the passivation layer shown in FIG. 8.

It is noted that, on the one hand, the first passivation layer 111 includes the silicon oxide material, and based on this, the content of the silicon at the first surface e where the intermediate passivation layer 131 is in contact with the first passivation layer 111 is designed to be higher than that at the second surface f, so as to facilitate enrichment of the silicon at the first surface e compared with the second surface f, thereby facilitating a further improvement of the matching degree of the lattices at the interface where the intermediate passivation layer 131 and the first passivation layer 111 are in contact by increasing the content of the silicon at the first surface e, further reducing the defect state density at the first surface e, and thus further improving the passivation effect of the passivation layer 101 on the segmentation surface 110c. On the other hand, the second passivation layer 121 includes the metal oxide material, and based on this, the content of the metal element at the second surface f where the intermediate passivation layer 131 is in contact with the second passivation layer 121 is designed to be higher than that at the first surface e, so as to facilitate enrichment of the metal element at the second surface f, thereby facilitating a further improvement of the matching degree of the lattices at the interface where the intermediate passivation layer 131 and the second passivation layer 121 are in contact by increasing the content of the metal element at the second surface f, further reducing the defect state density at the second surface f, and thus further improving the passivation effect of the passivation layer 101 on the segmentation surface 110c.

In some embodiments, with reference to FIG. 8 and FIG. 9, the content of the silicon in the intermediate passivation layer 131 has a decreasing trend and the content of the metal element in the intermediate passivation layer 131 has an increasing trend in the direction Z from the first passivation layer 111 to the second passivation layer 121. In some cases, the direction Z from the first passivation layer 111 to the second passivation layer 121 is perpendicular to the segmentation surface 110c. In other words, the direction Z is perpendicular to the first direction X.

It is noted that the content of the silicon at the first surface e is higher than that at the second surface f, and the content of the metal element at the first surface e is lower than that at the second surface f, which is favorable for ensuring that the content of the silicon in the intermediate passivation layer 131 has the decreasing trend and the content of the metal element in the intermediate passivation layer 131 has the increasing trend in the direction from the first passivation layer 111 to the second passivation layer 121. Furthermore, both the silicon and the metal element in the intermediate passivation layer 131 have a trend change, that is, gradually change, which is beneficial to improving the performance stability of the intermediate passivation layer 131 and avoiding a sudden performance change caused by a sudden change of the element content in the intermediate passivation layer 131.

In some embodiments, as shown in FIG. 8 and FIG. 9, the intermediate passivation layer 131 may further contain oxygen, and the content of the oxygen in the intermediate passivation layer 131 has an increasing trend and then a decreasing trend in the direction Z from the first passivation layer 111 to the second passivation layer 121.

It is noted that, in order to improve the matching degree of the lattices at the interface where the intermediate passivation layer 131 is in contact with the first passivation layer 111 and improve the matching degree of the lattices at the interface where the intermediate passivation layer 131 is in contact with the second passivation layer 121, the silicon is designed to be enriched at the first surface e where the intermediate passivation layer 131 is in contact with the first passivation layer 111, and the metal element is enriched at the second surface f where the intermediate passivation layer 131 is in contact with the second passivation layer 121, so that the peak of the content of the oxygen in the intermediate passivation layer 131 is located in a middle portion along the direction from the first passivation layer 111 to the second passivation layer 121, so as to ensure that one of two ends of the intermediate passivation layer 131 is rich in silicon and the other end is rich in metal elements. Based on this, the content of the oxygen in the intermediate passivation layer 131 is designed to have the increasing trend and then the decreasing trend, so as to ensure a high passivation effect of the passivation layer 101 on the segmentation surface 110c.

It should be noted that, in some embodiments, the increasing trend of a parameter means that the parameter gradually increases. That is, the parameter always increases gradually in a changing process. The decreasing trend of a parameter means that the parameter gradually decreases. That is, the parameter always decreases gradually in the changing process. In some other embodiments, the increasing trend of a parameter means that the parameter increases globally in the changing process, and the parameter can gradually decrease in a local changing process. The decreasing trend of a parameter means that the parameter decreases globally in the changing process, and the parameter can gradually increase in the local changing process. In other embodiments, the increasing trend of a parameter may mean that the parameter gradually increases, the decreasing trend of a parameter may mean that the parameter decreases globally, and in the local changing process, the parameter gradually increases. Or, the increasing trend of a parameter may mean that the parameter increases globally, and in the local changing process, the parameter gradually decreases, and the decreasing trend of a parameter means that the parameter gradually decreases. The above parameters include, but are not limited to, the content of the silicon in the intermediate passivation layer 131, the content of the metal element in the intermediate passivation layer 131, and the content of the oxygen in the intermediate passivation layer 131.

Furthermore, FIG. 9 only shows an example of the variation trends of the contents of the silicon, the metal elements, and the oxygen in a partial region of the segmented solar cell 110 and the passivation layer 101. In practical applications, the variation trends of the contents of the silicon, the metal elements, and the oxygen in the segmented solar cell 110 and the passivation layer 101 may be partially or completely different from those in the example shown in FIG. 9. In some examples, the metal element in FIG. 9 may be aluminum.

In some embodiments, the material of the intermediate passivation layer 131 may be a common oxide of silicon and aluminum, and the material of the second passivation layer 121 may be an aluminum oxide material.

In some embodiments, referring to FIG. 8, in the direction Z from the first passivation layer 111 to the second passivation layer 121, a thickness D1 of the first passivation layer 111 is smaller than a thickness D3 of the intermediate passivation layer 131, and the thickness D3 of the intermediate passivation layer 131 is smaller than a thickness D2 of the second passivation layer 121.

It is noted that the first passivation layer 111 contains the silicon oxide material, and when the thickness (i.e., D1) of the film containing the silicon oxide material in the direction Z is small, it can ensure that the first passivation layer 111 brings a good chemical passivation effect on the segmentation surface 110c, and a formation process of the first passivation layer 111 with a small D1 is simpler than a formation process of the first passivation layer 111 with a large thickness. In addition, in the case where the intermediate passivation layer 131 contains the oxygen, the small thickness D1 of the first passivation layer 111 is also beneficial to making oxygen atoms in the intermediate passivation layer 131 more easily migrate to the segmentation surface 110c, so as to further improve the chemical passivation effect on the segmentation surface 110c.

The intermediate passivation layer 131 serves as the transition layer between the first passivation layer 111 and the second passivation layer 121, and the thickness D3 of the intermediate passivation layer 131 in the direction Z should be proper, and preferably facilitates migration of the oxygen atoms in the intermediate passivation layer 131 to the segmentation surface 110c. Moreover, the second passivation layer 121 contains the metal oxide material, and in the direction Z, in a thickness range, the greater the thickness of the film containing the metal oxide material, the better the field effect passivation effect of the second passivation layer 121 on the segmentation surface 110c. Therefore, in the direction Z, the thickness D2 of the second passivation layer 121 is designed to be largest, the thickness D1 of the first passivation layer 111 is designed to be smallest, and the thickness D3 of the intermediate passivation layer 131 is designed to be between D1 and D2, which may ensure that the first passivation layer 111 brings the good chemical passivation effect on the segmentation surface 110c, as well as ensure that the second passivation layer 121 brings the good field effect passivation effect on the segmentation surface 110c, and is beneficial to migrating the oxygen atoms in the intermediate passivation layer 131 to the segmentation surface 110c.

In some embodiments, referring to FIG. 8, in the direction Z, the thickness D1 of the first passivation layer 111 may range from 1 nm to 10 nm. In some examples, the thickness D1 of the first passivation layer 111 may range from 4 nm to 7 nm, and may be for example 4.5 nm, 5 nm, 5.5 nm, 6 nm, 6.5 nm, or the like.

In some embodiments, referring to FIG. 8, in the direction Z, the thickness D2 of the second passivation layer 121 may range from 20 nm to 100 nm. In some examples, the thickness D2 of the second passivation layer 121 may range from 40 nm to 60 nm, and may be for example 45 nm, 48 nm, 50 nm, 53 nm, 55 nm, 58 nm, or the like.

In some embodiments, referring to FIG. 8, in the direction Z, the thickness D3 of the intermediate passivation layer 131 may range from 4 nm to 15 nm. In some examples, the thickness D3 of the intermediate passivation layer 131 may range from 8 nm to 12 nm, and may be for example 8.5 nm, 9 nm, 9.5 nm, 10 nm, 10.5 nm, 11 nm, 11.5 nm, or the like.

In some embodiments, the intermediate passivation layer 131 may further include the oxygen, and in the intermediate passivation layer 131, the content of the silicon ranges from 2% to 60%, the content of the metal element ranges from 2% to 50%, and the content of the oxygen ranges from 38% to 50%.

It should be noted that the content of the silicon in the intermediate passivation layer 131 ranging from 2% to 60% means that an average value of the contents of the silicon in the intermediate passivation layer 131 ranges from 2% to 60%, and the contents of the silicon in different regions of the intermediate passivation layer 131 may or may not be within the range of the average value. Similarly, the content of the metal element in the intermediate passivation layer 131 ranging from 2% to 50% means that an average value of the contents of the metal elements in the intermediate passivation layer 131 ranges from 2% to 50%, and the contents of the metal elements in different regions of the intermediate passivation layer 131 may or may not be within the range of the average value. The content of the oxygen in the intermediate passivation layer 131 ranging from 38% to 50% means that an average value of the contents of the oxygen in the intermediate passivation layer 131 ranges from 38% to 50%, and the contents of the oxygen in different regions of the intermediate passivation layer 131 may or may not be within the range of the average value.

In some cases, for the region of the intermediate passivation layer 131 where the content of the silicon is greatest, for example, the region at the first surface e, the content of the silicon in the region ranges from 40% to 80%, and may be for example 60%. For the region of the intermediate passivation layer 131 where the content of the silicon is smallest, for example, the region at the second surface f, the content of the silicon in the region ranges from 2% to 5%, and may be for example 3%.

In some cases, for the region of the intermediate passivation layer 131 where the content of the metal element is smallest, for example, the region at the first surface e, the content of the metal element in the region ranges from 2% to 5%, and may be for example 3%. For the region of the intermediate passivation layer 131 where the content of the metal element is greatest, for example, the region at the second surface f, the content of the metal element in the region ranges from 30% to 70%, and may be for example 50%.

In some cases, for the region of the intermediate passivation layer 131 where the content of the oxygen is greatest, for example, the middle region of the intermediate passivation layer 131, the content of the oxygen in the region ranges from 45% to 60%, and may be for example 60%. For the region of the intermediate passivation layer 131 where the content of the oxygen is smallest, for example, the region at the first surface e or the second surface f, the content of the oxygen in the region ranges from 20% to 40%, and may be for example 20%.

It should be noted that, for the intermediate passivation layer 131, the sum of the content of the silicon, the content of the metal element, and the content of the oxygen may or may not be 100%. In the case where the sum of the content of the silicon, the content of the metal element, and the content of the oxygen is not 100%, the intermediate passivation layer 131 further includes other impurity elements, such as hydrogen, so that the intermediate passivation layer 131 also brings the hydrogen passivation effect on the segmentation surface 110c. It is noted that, in the technology for forming the second passivation layer 121, other impurity elements than the silicon, the oxygen, and the metal element may be introduced in the second passivation layer 121.

In some embodiments, as shown in FIG. 8 and FIG. 9, in the direction Z, the first passivation layer 111 has a third surface g away from the second passivation layer 121 and a first surface e close to the second passivation layer 121. The content of the silicon at the third surface g is higher than that at the first surface e, and the content of the oxygen at the third surface g is lower than that at the first surface e.

It is noted that the third surface g is an interface where the first passivation layer 111 and the segmentation surface 110c are in contact, most of the region of the segmentation surface 110c is formed by a side surface of a substrate 160 in the segmented solar cell 110, and the substrate 160 may be made of a silicon base material. Based on this, the content of the silicon at the third surface g where the first passivation layer 111 and the segmentation surface 110c are in contact is designed to be higher than that at the first surface e, which is favorable for enriching the silicon at the third surface g compared with the first surface e, so as to be favorable for further improving the matching degree of lattices at the interface where the first passivation layer 111 and the segmentation surface 110c are in contact by improving the content of the silicon at the third surface g, and further reduce the defect state density at the third surface g, thereby further improving the passivation effect of the first passivation layer 111 on the segmentation surface 110c. Moreover, in order to make the content of the silicon at the third surface g higher than that at the first surface e, the content of the oxygen at the third surface g is designed to be lower than that at the first surface e to ensure the high passivation effect of the first passivation layer 111 on the segmentation surface 110c.

In some embodiments, as shown in FIG. 8 and FIG. 9, the content of the silicon in the first passivation layer 111 has a decreasing trend and the content of the oxygen in the first passivation layer 111 has an increasing trend in the direction Z from the first passivation layer 111 to the second passivation layer 121. Thus, both the silicon and the oxygen in the first passivation layer 111 have a trend change, that is, gradually change, which is beneficial to improving the performance stability of the first passivation layer 111 and avoiding a sudden performance change caused by a sudden change of the element content in the first passivation layer 111.

It should be noted that "increasing trend", "cases included in the increasing trend", "decreasing trend", and "cases included in the decreasing trend" have been described in detail above, and the description related to the decreasing trend of the content of the silicon in the first passivation layer 111 and the increasing trend of the content of the oxygen in the first passivation layer 111 is not repeated herein.

In some embodiments, in the direction Z, the second passivation layer 121 has a fourth surface h away from the first passivation layer 111 and a second surface close to the first passivation layer 111. The content of the oxygen at the second surface f is higher than that at the fourth surface h, and the content of the metal element at the second surface f is lower than that at the fourth surface h.

It is noted that, whether the first passivation layer 111 and the second passivation layer 121 are in direct contact or the intermediate passivation layer 131 is arranged between the first passivation layer 111 and the second passivation layer 121, the content of the oxygen at the second surface f is designed to be higher than that at the fourth surface h, which is favorable for enriching the oxygen at the second surface f compared with the fourth surface h, and thus more favorable for migrating more oxygen atoms to the segmentation surface 110c, so as to improve the passivation effect of the passivation layer 101 on the segmentation surface 110c. Moreover, in order to make the content of the oxygen at the second surface f higher than that at the fourth surface h, the content of the metal element at the second surface f is designed to be lower than that at the fourth surface h to ensure the high passivation effect of the second passivation layer 121 on the segmentation surface 110c.

In some embodiments, as shown in FIG. 8 and FIG. 9, the content of the oxygen in the second passivation layer 121 has a decreasing trend and the content of the metal element in the second passivation layer 121 has an increasing trend in the direction Z from the first passivation layer 111 to the second passivation layer 121. Thus, both the oxygen and the metal element in the second passivation layer 121 have a trend change, that is, gradually change, which is beneficial to improving the performance stability of the second passivation layer 121 and avoiding a sudden performance change caused by a sudden change of the element content in the second passivation layer 121.

It should be noted that "increasing trend", "cases included in the increasing trend", "decreasing trend", and "cases included in the decreasing trend" have been described in detail above, and the description related to the decreasing trend of the content of the oxygen in the second passivation layer 121 and the increasing trend of the content of the metal element in the second passivation layer 121 is not repeated herein.

In some embodiments, in the first passivation layer 111, the content of the silicon ranges from 60% to 98%, and the content of the oxygen ranges from 2% to 40%.

It should be noted that the content of the silicon in the first passivation layer 111 ranging from 60% to 98% means that an average value of the contents of the silicon in the first passivation layer 111 ranges from 60% to 98%, and the contents of the silicon in different regions of the first passivation layer 111 may or may not be within the range of the average value. Similarly, the content of the oxygen in the first passivation layer 111 ranging from 2% to 40% means that an average value of the contents of the oxygen in the first passivation layer 111 ranges from 2% to 40%, and the contents of the oxygen in different regions of the first passivation layer 111 may or may not be within the range of the average value.

In some cases, for the region of the first passivation layer 111 where the content of the silicon is greatest, for example, the region at the third surface g, the content of the silicon in the region ranges from 90% to 98%, and may be for example 95%. For the region of the first passivation layer 111 where the content of the silicon is smallest, for example, the region at the first surface e, the content of the silicon in the region ranges from 40% to 80%, and may be for example 60%.

In some cases, for the region of the first passivation layer 111 where the content of the oxygen is smallest, for example, the region at the third surface g, the content of the oxygen in the region ranges from 2% to 5%, and may be for example 3%. For the region of the first passivation layer 111 where the content of the oxygen is greatest, for example, the region at the first surface e, the content of the oxygen in the region ranges from 20% to 60%, and may be for example 40%.

It should be noted that, for the first passivation layer 111, the sum of the content of the silicon and the content of the oxygen may or may not be 100%. In the case where the sum of the content of the silicon and the content of the oxygen is not 100%, the first passivation layer 111 further includes other impurity elements, such as hydrogen, so that the first passivation layer 111 also brings the hydrogen passivation effect on the segmentation surface 110c. It is noted that, in a technology for forming the first passivation layer 111, other impurity elements than the silicon, the oxygen, and the metal element may be introduced in the first passivation layer 111.

In some embodiments, in the second passivation layer 121, the content of the metal element ranges from 45% to 65%, and the content of the oxygen ranges from 35% to 55%.

It should be noted that the content of the metal element in the second passivation layer 121 ranging from 45% to 65% means that an average value of the contents of the metal elements in the second passivation layer 121 ranges from 45% to 65%, and the contents of the metal elements in different regions of the second passivation layer 121 may or may not be within the range of the average value. Similarly, the content of the oxygen in the second passivation layer 121 ranging from 35% to 55% means that an average value of the contents of the oxygen in the second passivation layer 121 ranges from 35% to 55%, and the contents of the oxygen in different regions of the second passivation layer 121 may or may not be within the range of the average value.

In some cases, for the region of the second passivation layer 121 where the content of the metal element is greatest, for example, the region at the fourth surface h, the content of the metal element in the region ranges from 55% to 75%, and may be for example 70%. For the region of the first passivation layer 111 where the content of the metal element is smallest, the content of the metal element in the region ranges from 25% to 50%, and may be for example 30%.

In some cases, for the region of the second passivation layer 121 where the content of the oxygen is smallest, the content of the oxygen in the region ranges from 25% to 45%, and may be for example 30%. For the region of the second passivation layer 121 where the content of the oxygen is greatest, the content of the oxygen in the region ranges from 50% to 70%, and may be for example 55%.

It should be noted that, for the second passivation layer 121, the sum of the content of the silicon and the content of the metal element may or may not be 100%. In the case where the sum of the content of the silicon and the content of the metal element is not 100%, the second passivation layer 121 further includes other impurity elements, such as hydrogen, so that the second passivation layer 121 also brings the hydrogen passivation effect on the segmentation surface 110c. It is noted that, in the technology for forming the second passivation layer 121, other impurity elements than the silicon, the oxygen, and the metal element may be introduced in the second passivation layer 121.

In some embodiments, the first passivation layer 111 may be made of SiₐO_{b}, a/b∈[1.5, 49], and a/b represents a ratio of the contents of the silicon and the oxygen in the first passivation layer 111.

In some embodiments, the intermediate passivation layer 131 may be made of SiAlᵢOⱼ, i/j ∈ [0.04, 1.31], and i/j represents a ratio of the contents of the aluminum and the oxygen in the intermediate passivation layer 131.

In some embodiments, the second passivation layer 121 may be made of AlₘOₙ, m/n∈[1, 1.2], and m/n represents a ratio of the contents of the aluminum and the oxygen in the second passivation layer 121.

It should be noted that the chemical formula SiaO_{b} containing "a" and "b" herein represents the content percentage of the silicon and the oxygen in the first passivation layer 111, the chemical formula SiAlᵢOⱼ containing "i" and "j" herein represents the content percentage of the aluminum and the oxygen in the second passivation layer 121, and the chemical formula AlₘOₙ containing "m" and "n" herein represents the content percentage of the aluminum and the oxygen in the intermediate passivation layer 131. Each of SiₐO_{b}, SiAlᵢOⱼ, and AlₘOₙ does not represent a strict chemical formula or structure, and therefore, each of the SiₐO_{b}, the SiAlᵢOⱼ and the AlₘOₙ may include one or more stoichiometric compounds and/or one or more non-stoichiometric compounds. Values of "a" and "b" (if present) may or may not be integers, values of "i" and "j" (if present) may or may not be integers, and values of "m" and "n" (if present) may or may not be integers.

As used herein, the term "non-stoichiometric compound" means and includes a compound having a certain element composition which cannot be represented by a ratio of well-defined natural numbers and does not violate the law of constant composition. The content of each element in the first passivation layer 111, the second passivation layer 121, and the intermediate passivation layer 131 can be tested, measured and confirmed by using an energy dispersive spectrometer (EDS), electron energy loss spectroscopy (EELS), secondary ion mass spectroscopy (SIMS), or the like. For example, a particular line region or area region is selected for testing by a measuring device.

In some embodiments, referring to FIG. 1 to FIG. 5, at least some of the segmented solar cells 110 have side surfaces 110d not subjected to the segmentation. As shown in FIG. 2 and FIG. 10, the segmented solar cell 110 includes: a base 120 having a first face 120a and a second face 120b opposite in a second direction Y; a first passivation film 130 located on the first face 120a; a second passivation film 140 located on the second face 120b; and a side surface passivation film 150 located on the side surface 110d, the side surface 110d passivation film and the first passivation film 130 containing same materials, or the side surface 110d passivation film and the second passivation film 140 containing same materials.

FIG. 10 is a fourth schematic partial segmentation surfaceal structure diagram of the solar cell according to one or more embodiments of the present disclosure.

It should be noted that, referring to FIG. 3 or FIG. 4, the segmented solar cell 110 has the side surface 110d not subjected to the segmentation. In practical applications, all four side surfaces of some of the segmented solar cells 110 are segmentation surfaces 110c formed by segmentation. For example, referring to FIG. 5, the whole solar cell 100 is segmented into 9 segmented solar cells 110 according to a 3×3 array arrangement, and therefore, all four side surfaces of the segmented solar cell 110 located in the center are segmentation surfaces 110c.

In some examples, the side surface passivation film 150, the first passivation film 130, and the second passivation film 140 contain the same materials, so that the side surface passivation film 150, the first passivation film 130, and the second passivation film 140 may be formed using the same preparation process, which is favorable for simplifying the preparation process and reducing preparation costs of the side surface passivation film 150, the first passivation film 130, and the second passivation film 140.

In some other examples, the first passivation film 130 and the second passivation film 140 may be formed using different preparation processes, and the side surface passivation film 150 may be formed using the same preparation process as one of the first passivation film 130 and the second passivation film 140.

It should be noted that the specific configuration of the side surface passivation film 150 is different from that of the passivation layer 101. For example, the side surface passivation film 150 is of a single-layer structure different from a tandem structure of the passivation layer 101; or, the side surface passivation film 150 has a tandem structure, but at least part of the side surface passivation film 150 is made of a different material from at least part of the passivation layer 101.

In some cases, the side surface passivation film 150 and the passivation layer 101 are not formed using the same preparation process.

In some embodiments, the side surface passivation film 150 may have a tandem structure formed by a first side surface passivation film, a second side surface passivation film, and a third side surface passivation film stacked in the direction Z. In some examples, the first side surface passivation film may be made of a silicon material, the second side surface passivation film may be made of an aluminum oxide material, and the third side surface passivation film may be made of a silicon nitride material. A thickness of the second side surface passivation film in the direction Z may be 5 nm.

In some embodiments, the side surface passivation film 150 may have a single-layer structure, and the side surface passivation film 150 is made of a silicon oxynitride material. In some examples, the thickness of the side surface passivation film 150 in the direction Z may be 70 nm.

In some embodiments, referring to FIG. 1, FIG. 6, or FIG. 10, in the segmented solar cell 110, both the segmentation surface 110c and the side surface 110d are connected with the front sub-surface 110a and the back sub-surface 110b in the second direction Y. Referring to FIG. 10, a surface of the first passivation film 130 away from the first face 120a in the second direction Y is the front sub-surface 110a, and a surface of the second passivation film 140 away from the second face 120b in the second direction Y is the back sub-surface 110b.

It is noted that the segmentation surface 110c and the side surface 110d may include a side surface of the base 100 as well as side surfaces of the first passivation film 130 and the second passivation film 140. In other words, both the segmentation surface 110c and the side surface 110d are side surfaces of the whole segmented solar cell 110.

In some embodiments, the segmented solar cell 110 may include an interdigitated back contact (IBC) cell, a tunnel oxide passivated contact (TOPCon) cell, or a passivated emitter and rear cell (PERC).

It should be noted that each of the above three cells may include the passivation layer 101, the side surface passivation film 150, the first passivation film 130, and the second passivation film 140 in the foregoing embodiments.

For example, the following description will be given with the TOPCon cell as the segmented solar cell 110.

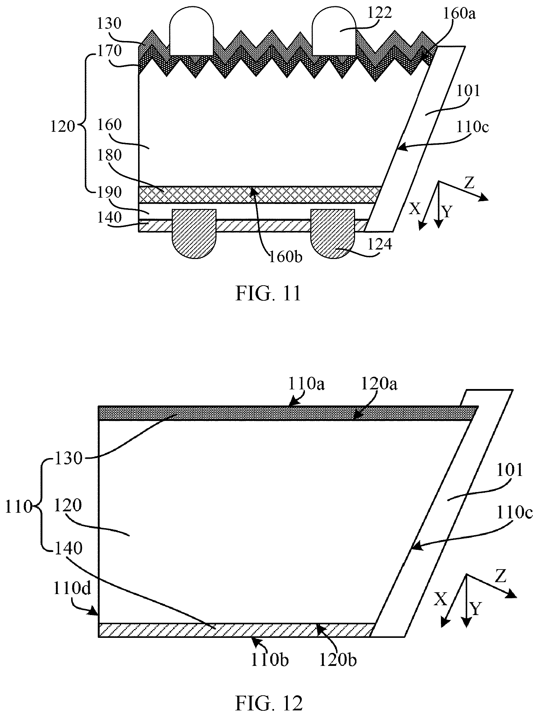

In some embodiments, as shown in FIG. 10 and FIG. 11 which is a fifth schematic partial segmentation surfaceal structure diagram of the solar cell according to one or more embodiments of the present disclosure, the base 120 may include: a substrate 160 having a third surface 160a and a fourth surface 160b opposite in the second direction Y, the third surface 160a being close to the first face 120a, and the fourth surface 160b being close to the second face 120b; an emitter 170 located on the third surface 160 a; a tunnel dielectric layer 180 located on the fourth surface 160b; and a doped conductive layer 190 located on a side of the tunnel dielectric layer 180 away from the fourth surface 160b. The first passivation film 130 is located on a side of the emitter 170 away from the third surface 160a, and the second passivation film 140 is located on a side of the doped conductive layer 190 away from the tunnel dielectric layer 180.

In some cases, the substrate 160 is made of a silicon base material, such as one or more of monocrystalline silicon, polycrystalline silicon, amorphous silicon, or microcrystalline silicon. In some examples, the substrate 160 may be an N-type semiconductor base, the substrate 160 may include N-type doped elements (e.g., phosphorus, arsenic, antimony, or the like), the emitter 170 may include P-type doped elements, and the emitter 170 and the substrate 160 form a PN junction.

In some cases, with continued reference to FIG. 11, the segmented solar cell 110 can further include a first electrode 122 in electrical contact with the emitter 170. In some examples, the first electrode 122 is in electrical contact with the emitter 170 through the first passivation film 130.

In some cases, with continued reference to FIG. 11, the segmented solar cell 110 can further include a second electrode 123 in electrical contact with the doped conductive layer 190. In some examples, the second electrode 123 is in electrical contact with the doped conductive layer 190 through the second passivation film 140.

In the above embodiments, in some embodiments, each of the first passivation film 130 and the second passivation film 140 may be of a single-layer structure or a tandem structure, and each of the first passivation film 130 and the second passivation film 140 may be made of at least one of silicon oxide, silicon nitride, silicon oxynitride, silicon oxycarbonitride, titanium oxide, hafnium oxide, or aluminum oxide.

In some embodiments, the segmented solar cell 110 may further include electrode pads located on the first electrode 122 and the second electrode 123, so that an electrical connection between adjacent segmented solar cells 110 can be conveniently realized by using solder strips and the electrode pads subsequently. Some of the electrode pads will be described in detail later.

It is noted that "the passivation layer 101 is at least located on the segmentation surface 110c" includes at least the following embodiments.

In some embodiments, referring to FIG. 12 which is a sixth schematic partial segmentation surfaceal structure diagram of the solar cell according to one or more embodiments of the present disclosure, the passivation layer 101 is further located on part of a surface of the first passivation film 130 away from the first face 120a in the second direction Y. It should be noted that, in the step of forming the passivation layer 101 covering the segmentation surface 110c, a raw material required for preparing the passivation layer 101 may diffuse towards the surface of the first passivation film 130 connected with the segmentation surface 110c by a certain distance, and thus, the passivation layer 101 is also formed on part of the surface of the first passivation film 130 away from the first face 120a in the second direction Y.

In some cases, on the surface of the first passivation film 130 away from the first face 120a in the second direction Y, an area ratio of the part provided with the passivation layer 101 to the entire surface is not more than 5%, and for example, the area ratio of the part on the surface of the first passivation film 130 provided with the passivation layer 101 to the entire surface may be 4.5%, 4%, 3.5%, 3%, 2.5%, 2%, or the like. In this way, the distance by which the raw material required for preparing the passivation layer 101 diffuses towards the surface of the first passivation film 130 is small, which is beneficial to preventing the passivation layer 101 from being formed on the electrode pads for connecting the adjacent segmented solar cells 110, so as not to interfere with a sub-cell interconnection step in a process of forming the photovoltaic module. It is noted that, especially for the solar cell in which the first face 120a is required to be fully used, that is, an area of the first face 120a receiving light is required to be increased, electrodes located on the first face 120a become thinner and thinner, or the closer the electrodes are to an edge of the first face 120a, the more favorable the control over the area ratio of the region on the surface of the first passivation film 130 provided with the passivation layer 101 to the whole surface is to improving the conversion efficiency of the packaged photovoltaic module.

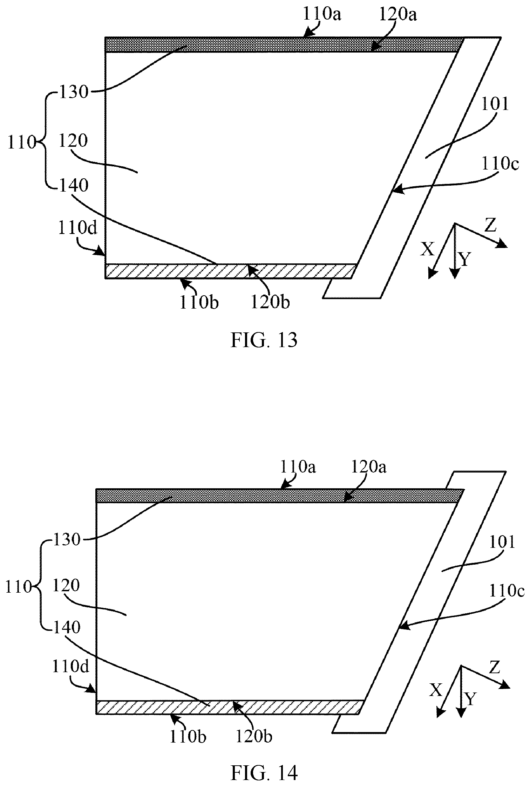

In some other embodiments, referring to FIG. 13 which is a seventh schematic partial segmentation surfaceal structure diagram of the solar cell according to one or more embodiments of the present disclosure, the passivation layer 101 is further located on part of a surface of the second passivation film 140 away from the second face 120b in the second direction Y. It should be noted that, in the step of forming the passivation layer 101 covering the segmentation surface 110c, the raw material required for preparing the passivation layer 101 may diffuse towards the surface of the second passivation film 140 connected with the segmentation surface 110c by a certain distance, and thus, the passivation layer 101 is also formed on part of the surface of the second passivation film 140 away from the second face 120b in the second direction Y.

In some cases, on the surface of the second passivation film 140 away from the second face 120b in the second direction Y, an area ratio of the part provided with the passivation layer 101 to the entire surface is not more than 5%, and for example, the area ratio of the part on the surface of the first passivation film 130 provided with the passivation layer 101 to the entire surface may be 4.5%, 4%, 3.5%, 3%, 2.5%, 2%, or the like. In this way, the distance by which the raw material required for preparing the passivation layer 101 diffuses towards the surface of the second passivation film 140 is small, which is also beneficial to preventing the passivation layer 101 from being formed on the electrode pads for connecting the adjacent segmented solar cells 110, so as not to interfere with the sub-cell interconnection step in the process of forming the photovoltaic module.

In some other embodiments, referring to FIG. 14 which is an eighth schematic partial segmentation surfaceal structure diagram of the solar cell according to one or more embodiments of the present disclosure, the passivation layer 101 is further located on part of the surface of the first passivation film 130 away from the first face 120a in the second direction Y, and the passivation layer 101 is further located on part of the surface of the second passivation film 140 away from the second face 120b in the second direction Y.

In some cases, on the surface of the first passivation film 130 away from the first face 120a in the second direction Y, an area ratio of the part provided with the passivation layer 101 to the entire surface is not more than 5%, and on the surface of the second passivation film 140 away from the second face 120b in the second direction Y, an area ratio of the part provided with the passivation layer 101 to the entire surface is not more than 5%.

It should be noted that, for the description of the electrode pad in the above three embodiments, reference may be made to the foregoing embodiments, and details are not repeated herein.

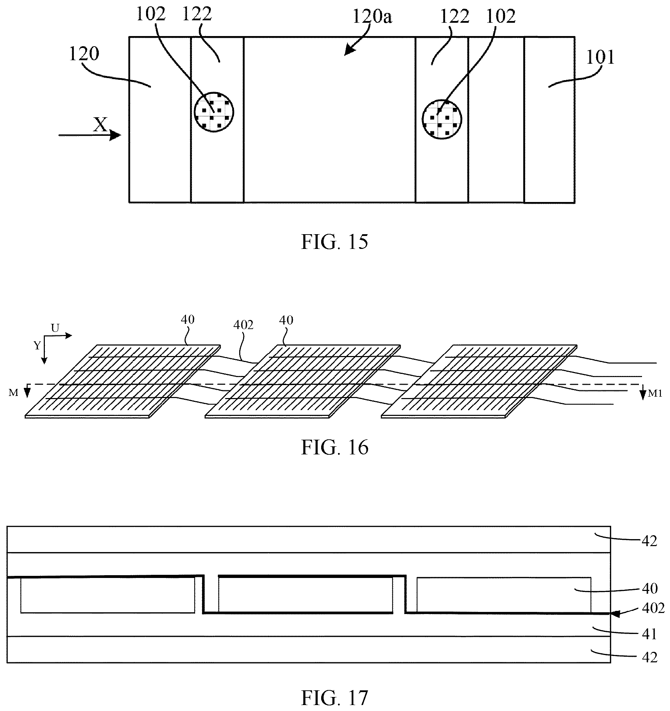

In some embodiments, as shown in FIG. 12 and FIG. 15, the solar cell may further include an edge electrode pad 102. The edge electrode pad 102 is located at the edge of the first face 120a, and a gap exists between the passivation layer 101 located on the surface of the first passivation film 130 and the edge electrode pad 102. In some other embodiments, referring to FIG. 13, the edge electrode pad (not shown) is located at the edge of the second face 120b, and a gap exists between the passivation layer 101 located on the surface of the second passivation film 140 and the edge electrode pad 102. In some other embodiments, referring to FIG. 14, the edge electrode pads (not shown) are located at both the edge of the first face 120a and the edge of the second face 120b, and gaps exist between the passivation layer 101 and the edge electrode pads (not shown).

In this way, it is beneficial to ensuring that the passivation layer 101 does not cover the edge electrode pad 102, and further does not cover the electrode pad in a middle region of the segmented solar cell 110, which is beneficial to further preventing the passivation layer 101 from interfering with the sub-cell interconnection step in the process of forming the photovoltaic module.

It should be noted that FIG. 15 is a schematic partial top structure diagram of the solar cell according to one or more embodiments of the present disclosure. Furthermore, based on the type of the segmented solar cell 110, the edge electrode pads 102 may be located at the edge of only one of the first face 120a and the second face 120b, or located at the edge of the first face 120a and the edge of the second face 120b. In addition, FIG. 15 only shows the edge electrode pad 102 located on the first electrode 122 in an edge region, and in practical applications, the first electrode in the middle region is also provided with the electrode pad, and the second electrode is also provided with the electrode pad.

In summary, the angle between the segmentation surface 110c formed by segmentation and the back sub-surface 110b of the segmented solar cell 110 is not designed to be a right angle. That is, the whole solar cell 100 is obliquely cut to form the segmented solar cells 110, and the segmentation surface 110c of the segmented solar cell 110 can be regarded as an inclined surface for the front sub-surface 110a and the back sub-surface 110b of the segmented solar cell 110. Based on this, compared with the manner of segmenting the whole solar cell 100 in the second direction Y to form the segmentation surface 110c of the segmented solar cell 110, in some embodiments of the present disclosure, the atom arrangement density on the inclined segmentation surface 110c designed on the segmented solar cell 110 is smaller, the covalent bond surface density is smaller, and the connection between adjacent atoms on the segmentation surface is not firm, which is more favorable for promoting the passivation layer 101 on the segmentation surface 110c to form the bonds with the dangling bonds on the segmentation surface 110c; that is, the passivation layer 101 more easily saturates the dangling bonds on the segmentation surface 110c. The passivation layer 101 can also passivate other surface defects on the segmentation surface 110c, which is favorable for further improving the capability of the passivation layer 101 to reduce the defect state density of the segmentation surface 110c, so as to further reduce the recombination centers of the segmentation surface 110c to reduce the recombination probability of the carriers. In other words, the segmentation surface 110c of the segmented solar cell 110 is designed to be inclined relative to the back sub-surface 110b thereof rather than perpendicular to the back sub-surface, which is favorable for further improving the passivation effect of the passivation layer 101 on the segmentation surface 110c in cooperation with the passivation function of the passivation layer 101, so as to further reduce the probability of recombination of the carriers on the segmentation surface 110c and prolong the service life of the carriers, thereby further improving the photoelectric conversion efficiency of the segmented solar cell 110.

One or more embodiments of the present disclosure further provide a preparation method of a solar cell, which is used to prepare the solar cell according to the foregoing embodiments. The preparation method of a solar cell according to one or more embodiments of the present disclosure will be described in detail below with reference to the accompanying drawings. It should be noted that the same or corresponding parts as those in the previous embodiments are not repeated herein.

Referring to FIG. 1 to FIG. 5, the preparation method of a solar cell includes: providing a whole solar cell 100; segmenting the whole solar cell 100 with an entire thickness in a first direction X to form at least two segmented solar cells 110, wherein the thickness of the whole solar cell 100 is the same as that of the segmented solar cells 110 in a second direction Y; the second direction Y is a thickness direction of the segmented solar cell 110, the first direction X is intersected with the second direction Y, the segmented solar cell 110 has a front sub-surface 110a and a back sub-surface 110b which are oppositely arranged in the second direction Y, the segmented solar cell 110 also has a segmentation surface 110c formed by the segmentation, two angles which are supplementary angles to each other are formed between the segmentation surface 110c and a plane where the back sub-surface 110b is located, and one of the angles is an acute angle; and forming a passivation layer 101 at least on the segmentation surface 110c.

In some embodiments, the step of forming a passivation layer 101 may include the following cases. In some cases, referring to FIG. 2, the passivation layer 101 is formed only on the segmentation surface 110c. In some other cases, referring to FIG. 12, on the basis of forming the passivation layer 101 on the segmentation surface 110c, the passivation layer 101 is also formed on part of the front sub-surface 110a of the segmented solar cell 110. In some other cases, referring to FIG. 13, on the basis of forming the passivation layer 101 on the segmentation surface 110c, the passivation layer 101 is also formed on part of the back sub-surface 110b of the segmented solar cell 110. In some other cases, referring to FIG. 14, on the basis of forming the passivation layer 101 on the segmentation surface 110c, the passivation layers 101 are formed on part of the front sub-surface 110a and part of the back sub-surface 110b of the segmented solar cell 110.

In some embodiments, referring to FIG. 6, the step of forming a passivation layer 101 may further include: forming a first passivation layer 111 on at least the segmentation surface 110c; and forming a second passivation layer 121 on a side of the first passivation layer 111 away from the segmented solar cell 100.

In some examples, referring to FIG. 11, after forming the first passivation layer 111 and before forming the second passivation layer 121, the preparation method may further include: forming an intermediate passivation layer 131 on the side of the first passivation layer 111 away from the segmented solar cell 100; the step of forming a second passivation layer 121 includes: forming the second passivation layer 121 on a side of the intermediate passivation layer 131 away from the first passivation layer 111.

It is noted that, in the second direction Y, the thickness of the whole solar cell 100 is the same as that of the segmented solar cell 110, so that the segmented solar cell 110 is formed by cutting the whole solar cell 100 from the front surface 100a to the back surface 100b thereof, or from the back surface 100b to the front surface 100a thereof. Moreover, a cutting direction of the whole solar cell 100 is defined. That is, the same whole solar cell 100 is segmented in the first direction X to form the segmented solar cell 110, and the first direction X is intersected with the thickness direction of the segmented solar cell 110. In other words, the whole solar cell 100 is obliquely cut to form the segmented solar cells 110, and the segmentation surface of the segmented solar cell 110 can be regarded as an inclined surface for the front sub-surface 110a and the back sub-surface 110b of the segmented solar cell 110.

Based on this, by virtue of the characteristics that the atom arrangement density on the inclined segmentation surface 110c designed on the segmented solar cell 110 is smaller and the covalent bond surface density thereon is smaller, after the passivation layer 101 is formed on the segmentation surface 110c, it is more favorable for promoting the passivation layer 101 and dangling bonds on the segmentation surface 110c to form bonds, so as to further improve the capability of the passivation layer 101 to reduce the defect state density of the segmentation surface 110c, further reduce the probability of recombination of carriers on the segmentation surface 110c, and prolong the lifetime of the carriers, thereby further improving the photoelectric conversion efficiency of the segmented solar cell 110.

One or more embodiments of the present disclosure further provide a photovoltaic module for converting received light energy into electric energy. The photovoltaic module according to one or more embodiments of the present disclosure will be described in detail below with reference to the accompanying drawings. FIG. 16 is a schematic partial perspective structure diagram of the photovoltaic module according to one or more embodiments of the present disclosure. FIG. 17 is a schematic segmentation surfaceal structure diagram taken along segmentation surfaceal direction MM1 in FIG. 16. It should be noted that the same or corresponding parts as those in the previous embodiments are not repeated herein.

Referring to FIG. 16 and FIG. 17, the photovoltaic module includes: a solar cell string formed by connecting a plurality of solar cells 40 according to the foregoing embodiments or by connecting a plurality of solar cells 40 prepared by the preparation method according to the foregoing embodiments; a packaging adhesive film 41 for covering a surface of the solar cell string; and a cover plate 42 for covering a surface of the packaging adhesive film 41 away from the solar cell string.

It is noted that the solar cells 40 are electrically connected to form a plurality of solar cell strings, and the plurality of solar cell strings are electrically connected in series and/or in parallel. Since the solar cell 40 includes the segmented solar cell 110, and the segmented solar cell 110 is formed after the whole solar cell 100 is segmented, the power loss of the photovoltaic module can be improved by current reduction of the segmented solar cell 110, so as to improve the photoelectric conversion efficiency of the photovoltaic module.

In some embodiments, referring to FIG. 17, the plural solar cell strings may be electrically connected by conductive strips 402. FIG. 17 merely shows a positional relationship between the solar cells. That is, the electrodes of the solar cells having the same polarity are arranged in the same direction, or the electrodes of each solar cell having the positive polarity are arranged towards the same side, so that the conductive strip is connected with different sides of two adjacent solar cells. In some embodiments, the electrodes of the solar cells with different polarities may be arranged towards the same side. That is, the electrodes with a first polarity and the electrodes with a second polarity of the plural adjacent solar cells are alternatively arranged, so that the conductive strip is connected with the same sides of two adjacent solar cells.

In some embodiments, no gap is provided between the solar cells. That is, the solar cells are overlapped with each other.

In some embodiments, the packaging adhesive film 41 includes a first packaging layer covering one of the front surface and the back surface of the solar cell 40 and a second packaging layer covering the other of the front surface and the back surface of the solar cell 40. In some embodiments, at least one of the first packaging layer and the second packaging layer may be an organic packaging adhesive film, such as a polyvinyl butyral (PVB) adhesive film, an ethylene vinyl acetate (EVA) adhesive film, a polyolyaltha olfin (POE) adhesive film, a polyethylene terephthalate (PET) adhesive film, or the like.

In some cases, the first packaging layer and the second packaging layer have a boundary before lamination, and the concept of the first packaging layer and the second packaging layer does not exist after lamination. That is, the first packaging layer and the second packaging layer form the integral packaging adhesive film 41.

In some embodiments, the cover plate 42 may be a glass cover plate, a plastic cover plate, or the like, having a light transmitting function. In some embodiments, a surface of the cover plate 42 facing the packaging adhesive film 41 may be a concave-convex surface, so as to increase the utilization rate of incident light. The cover plate 42 includes a first cover plate opposite to the first packaging layer and a second cover plate opposite to the second packaging layer.

In some embodiments, referring to FIG. 16, the solar cells 40 in the solar cell string are arranged in a direction U, and busbars of every two adjacent solar cells 40 in the solar cell string are staggered in the third direction Z. For the photovoltaic module, by staggering the busbars of every two adjacent solar cells 40 in the solar cell string in the third direction Z, different potentials of the photovoltaic module can be tested to improve the reliability of a test result.

In some embodiments, the photovoltaic cell 40 includes, but is not limited to, one of a PERC, an IBC cell, a TOPCon cell, a heterojunction technology (HIT/HJT) cell, a solar thin-film cell and a tandem cell, or any combination thereof. The solar thin-film cell includes, but is not limited to, a perovskite solar thin-film cell, a copper indium selenium solar thin-film cell, a gallium arsenide solar thin-film cell, and a cadmium sulfide solar thin-film cell. Without limitations, the tandem cell is formed by laminating a perovskite cell and a crystalline silicon cell, a perovskite cell and a perovskite cell, as well as a perovskite cell and a thin-film cell.

## Claims

1. A solar cell (100) formed by a segmented solar cell (110), comprising a passivation layer (101, 111, 121, 131) at least located on a segmentation surface (110c) of the segmented solar cell;
wherein at least two segmented solar cells (110) are provided and formed by segmenting a same whole solar cell (100) in a first direction, wherein the whole solar cell (100) has a front surface (100a) and a back surface (100b) which are oppositely arranged in a second direction (Y), the segmented solar cell (110) has a front sub-surface (110a) and a back sub-surface (110b) which are oppositely arranged in the second direction (Y), the front sub-surfaces (110a) of the at least two segmented solar cells (110) formed based on the same whole solar cell (100) are partial regions of the front surface (100a), and the back sub-surfaces (110b) of the at least two segmented solar cells (110) formed based on the same whole solar cell (100) are partial regions of the back surface (100b);
the second direction (Y) is a thickness direction of the at least two segmented solar cells (110), the first direction (X) is intersected with the second direction (Y), each of the at least two segmented solar cells (110) has a segmentation surface (110c) formed by the segmenting, two angles which are supplementary angles to each other are formed between the segmentation surface (110c) and a plane where the back sub-surface (110b) is located, and one of the angles is an acute angle.

2. The solar cell according to claim 1, wherein each of the at least two segmented solar cells (110) comprises at least one segmentation surface (110c), and the passivation layer (101, 111, 121, 131) is located on each segmentation surface (110c).

3. The solar cell according to claim 1, wherein in one segmented solar cell, the front sub-surface (110a) has an area larger than an area of the back sub-surface (110b), a first angle is formed between the at least one segmentation surface (110c) and the back sub-surface (110b), and a supplementary angle to the first angle is the acute angle; and/or
in another segmented solar cell of the at least two segmented solar cells (110), the front sub-surface (110a) has an area smaller than that of the back sub-surface (110b), a second angle is formed between the at least one segmentation surface (110c) and the back sub-surface (110b), and the second angle is the acute angle.

4. The solar cell according to any one of claims 1 to 3, wherein the acute angle ranges from 45° to 80°.

5. The solar cell according to claim 1, wherein in a third direction, the passivation layer (101, 111, 121, 131) comprises at least a first passivation layer (111) and a second passivation layer (121) which are stacked;
the first passivation layer (111) comprises a silicon oxide material, the second passivation layer (121) comprises a metal oxide material, wherein
metal elements in the metal oxide material comprise at least one of Al, Ti, Zn, Zr, Hf, Mo, W, or Ni, and the third direction is perpendicular to the segmentation surface (110c).

6. The solar cell according to claim 5, wherein the passivation layer further comprises an intermediate passivation layer (131), the intermediate passivation layer (131) is located between the first passivation layer (111) and the second passivation layer (121);
wherein both the intermediate passivation layer (131) and the first passivation layer (111) contain silicon element, and the intermediate passivation layer (131) and the second passivation layer (121) contain same metal elements.

7. The solar cell according to claim 6, wherein the intermediate passivation layer (131) comprises oxides having the silicon element and the metal elements.

8. The solar cell according to claim 1, wherein orthographic projection of the back sub-surface (110b) of each of the at least two segmented solar cells (110) is rectangular, and corners of some rectangles are rounded corners.

9. The solar cell according to claim 6, wherein the intermediate passivation layer (131) and the first passivation layer (111) comprise a first surface that is in contact with each other, and the intermediate passivation layer (131) and the second passivation layer (121) comprise a second surface that is in contact with each other;
wherein, a content of the silicon element at the first surface is higher than a content of the silicon element at the second surface, and a content of the metal elements at the first surface is lower than a content of the metal element at the second surface.

10. The solar cell according to claim 9, wherein in a direction from the first passivation layer (111) towards the second passivation layer (121), a content of the silicon element in the intermediate passivation layer (131) decreases, and a content of the metal element in the intermediate passivation layer (131) increases.

11. The solar cell according to claim 6, wherein the intermediate passivation layer (131) also comprises oxygen element, and
in the direction from the first passivation layer (111) towards the second passivation layer (121), a content of the oxygen element in the intermediate passivation layer (131) increases at first and then decreases.

12. The solar cell according to claim 6, wherein along the first direction (X), a thickness of the first passivation layer (111) is less than a thickness of the intermediate passivation layer (131), and
the thickness of the intermediate passivation layer (131) is less than a thickness of the second passivation layer (121).

13. The solar cell according to claim 6, wherein along the first direction (X), a thickness of the first passivation layer (111) ranges from 1 nm to 10 nm, a thickness of the second passivation layer (121) ranges from 20 nm to 100 nm, and a thickness of the intermediate passivation layer (131) ranges from 4 nm to 15 nm.

14. A method for preparing a solar cell, comprising:
providing a whole solar cell (100);
segmenting the whole solar cell (100) with an entire thickness in a first direction (X) to form at least two segmented solar cells (110), wherein the thickness of the whole solar cell (100) is the same as a thickness of the at least two segmented solar cells (110) in a second direction (Y);
the second direction (Y) is a thickness direction of the segmented solar cell, the first direction (X) is intersected with the second direction (Y), each segmented solar cell of the at least two segmented solar cells (110) has a front sub-surface (110a) and a back sub-surface (110b) which are oppositely arranged in the second direction (Y), the segmented solar cell also has a segmentation surface (110c) formed by the segmenting, two angles which are supplementary angles to each other are formed between the segmentation surface (110c) and a plane where the back sub-surface (110b) is located, and one of the angles is an acute angle; and
forming a passivation layer (101, 111, 121, 131) at least on the segmentation surface (110c).

15. A photovoltaic module, comprising:
a solar cell string formed by connecting a plurality of solar cells according to claim 1 to 13 or by connecting a plurality of solar cells formed by the method according to claim 14;
a packaging adhesive film for covering a surface of the solar cell string; and
a cover plate for covering a surface of the packaging adhesive film away from the solar cell string.
